# EUROPÄISCHE PATENTANMELDUNG

(11) **EP 4 632 963 A1**
(43) Veröffentlichungstag der Anmeldung: **15.10.2025**
(21) Anmeldenummer: 25167958.5
(22) Anmeldetag: 02.04.2025
(51) Int. Cl.: H01R 13/518, F16B 33/02, H01R 13/52, H01R 13/74, H05K 5/02

(54) **ANBAUGEHÄUSE MIT BEFESTIGUNGSMITTEL ZUR EINFACHEN BEFESTIGUNG AN EINER GERÄTEWAND UND BAUGRUPPE**

(30) Priorität: 10.04.2024 DE 202024101736 U
(71) Anmelder: Harting International Innovation AG, 2504 Biel (CH)
(72) Erfinder: Penner, Simon, 2504 Biel (CH)
(74) Vertreter: noventive Patentanwaltsgesellschaft mbH

(57) **Zusammenfassung**

Die Erfindung betrifft ein Anbaugehäuse (1), wie es üblicherweise für Industriesteckverbinder verwendet wird, sowie eine Baugruppe, die unter anderem ein erfindungsgemäßes Anbaugehäuse (1) umfasst. Das erfindungsgemäße Anbaugehäuse (1) weist eine rahmenförmige Grundform (2) auf, welche einen Aufnahmebereich (3) zur Aufnahme eines Kontakteinsatzes umschließt, wobei die rahmenförmige Grundform (2) innenseitig mindestens eine Gehäusebefestigungsanformung (5) mit einer ersten Durchgangsöffnung (5a) zur Aufnahme eines Befestigungsmittels (6) aufweist. Das Anbaugehäuse (1) umfasst ferner ein Befestigungsmittel (6), das zumindest teilweise in der ersten Durchgangsöffnung (5a) der Gehäusebefestigungsanformung (5) drehbar gelagert angeordnet ist, und ist **dadurch gekennzeichnet, dass** das Befestigungsmittel (6) an einem Ende eine wendelförmige Struktur (6a) aufweist, wobei die wendelförmige Struktur (6a) zumindest teilweise aus der rahmenförmigen Grundform (2) herausragt.

## Beschreibung

### Technisches Gebiet

Die Erfindung betrifft ein Anbaugehäuse, wie es üblicherweise für Industriesteckverbinder verwendet wird, sowie eine Baugruppe, die unter anderem ein Anbaugehäuse umfasst.

Derartige Anbaugehäuse sind an sich bekannt. Anbaugehäuse werden beispielsweise an Wanddurchbrüchen von Schaltschrank- oder Maschinenwänden angebracht, um dort eine Möglichkeit für eine Steckverbindung zu schaffen.

### Stand der Technik

Die DE 20 2007 004 350 U1 zeigt ein Anbaugehäuse welches an einen Durchbruch einer Gerätewand montierbar ist. Das Anbaugehäuse hat eine rahmenförmige Grundform. An der rahmenförmigen Grundform sind außenseitig Befestigungsöffnungen angeformt, über die das Anbaugehäuse an die Gerätewand angeschraubt werden kann. Um eine Dichtigkeit des Anbaugehäuses gegenüber Umwelteinflüssen zu gewährleisten, weist das Anbaugehäuse an der dem Gerät zugewandten Seite eine Nut auf, in welche ein Dichtring eingelegt ist.

Die DE 10 2015 106 963 B4 zeigt ein an einer Gerätewand befestigtes Anbaugehäuse, welches an seinen Schmalseiten jeweils Befestigungsflächen mit jeweils zwei Schrauböffnungen, zur Fixierung des Anbaugehäuses an die Gerätewand, aufweist. Solche Schraubbefestigungen sind sowohl bei der Installation als auch bei der Wartung des Gerätes umständlich zu handhaben. Dennoch werden sie seit Jahrzehnten eingesetzt.

### Aufgabenstellung

Der vorliegenden Erfindung liegt die Aufgabe zugrunde, ein Anbaugehäuse sowie eine Baugruppe bereitzustellen, welche die Nachteile und Einschränkungen des Standes der Technik überwinden.

Der vorliegenden Erfindung liegt weiterhin die Aufgabe zugrunde, ein Anbaugehäuse sowie eine Baugruppe bereitzustellen, die eine einfache und robuste Montage des Anbaugehäuses an einer Gerätewand ohne Verwendung zusätzlicher Schrauben, z.B. an Schmalseiten des Anbaugehäuses, ermöglicht.

Erfindungsgemäß werden diese Aufgaben durch ein Anbaugehäuse und eine Baugruppe gemäß den unabhängigen Ansprüchen erfüllt. Weitere vorteilhafte Ausführungsformen sind in den Unteransprüchen, bzw. abhängigen Ansprüchen, angegeben.

In einem ersten Aspekt wird ein Anbaugehäuse offenbart. Das Anbaugehäuse weist eine rahmenförmigen Grundform auf, welche einen Aufnahmebereich zur Aufnahme eines Kontakteinsatzes umschließt, wobei die rahmenförmige Grundform innenseitig mindestens eine Gehäusebefestigungsanformung mit einer ersten Durchgangsöffnung zur Aufnahme eines Befestigungsmittels aufweist, das Anbaugehäuse ferner umfassend ein Befestigungsmittel, das zumindest teilweise in der ersten Durchgangsöffnung der Gehäusebefestigungsanformung drehbar gelagert angeordnet ist, wobei das Befestigungsmittel an einem Ende eine wendelförmige Struktur aufweist, wobei die wendelförmige Struktur zumindest teilweise aus der rahmenförmigen Grundform herausragt.

Das Befestigungsmittel, das innenseitig, d. h. in einem Innenvolumen des Anbaugehäuses angeordnet ist, dient zur Befestigung des Anbaugehäuses an einer Gerätewand. Da die wendelförmige Struktur des Befestigungsmittels aus der rahmenförmigen Grundform herausragt, kann diese durch Verdrehen in mechanischen Eingriff mit der Gerätewand gebracht werden, wodurch das Anbaugehäuse befestigt werden kann. Darüber hinaus ist die Anordnung des Befestigungsmittels auf der Innenseite nicht willkürlich gewählt. Durch die innenseitige Anordnung kann ein unbeabsichtigtes Berühren des Befestigungsmittels verhindert werden, da das Befestigungsmittel durch die rahmenförmige Struktur geschützt wird, was zu einer sicheren Befestigung des Anbaugehäuses an einer Gerätewand führen kann. Alternativ kann der Kontakteinsatz auch durch einen mit Steckverbindungermodulen bestückten Halterahmen ersetzt werden.

In einer ersten Weiterbildung des ersten Aspekts kann das Befestigungsmittel zwischen zwei Endstellungen drehbar sein, die einer Montagestellung und einer Befestigungsstellung entsprechen, wobei die wendelförmige Struktur in der Befestigungsstellung zumindest teilweise aus der rahmenförmigen Grundform hervorstehen kann.

Zumindest die Befestigungsstellung kann je nach Dicke der Gerätewand variieren. Es handelt sich also nicht um eine vorgegebene oder vorgebbare, sondern um eine von der Einbausituation abhängige Befestigungsstellung. Je nach Dicke der Gerätewand, mit der die wendelförmige Struktur des Befestigungsmittels in mechanischen Eingriff mit der Gerätewand gebracht wird, ändert sich die Winkelstellung des drehbar gelagerten Befestigungsmittels.

In einer zweiten Weiterbildung des ersten Aspekts kann die wendelförmige Struktur als Wendel mit mindestens einer zwölftel Windung, d.h. 30 Grad, und höchstens einer ganzen Windung, d.h. 360 Grad, ausgebildet sein. Vorzugsweise ist die wendelförmige Struktur mit weniger als einer vollen Windung, d.h. weniger als d.h. 360 Grad, ausgebildet, wodurch das Eingreifen der wendelförmigen Struktur in eine Gerätewand erleichtert wird.

In einer Weiterbildung des ersten Aspekts kann die wendelförmige Struktur bezüglich einer Rotationsachse rotationsasymmetrisch ausgebildet sein. Dies kann insbesondere dann der Fall sein, wenn die wendelförmige Struktur weniger als eine volle Windung aufweist, da sie dann nur in Bezug auf die Rotationsachse bzw. Drehachse des Befestigungsmittels rotationsasymmetrisch ist.

In einer weiteren Weiterbildung des ersten Aspekts, kann das Befestigungsmittel einen zur Aufnahme eines Werkzeugs ausgebildeten Kopf aufweisen, der an einem der wendelförmigen Struktur abgewandten Ende angeordnet sein kann. Das Werkzeug kann ein Schraubendreher, ein Innensechskantschlüssel oder ähnliches sein.

In einer Weiterbildung des ersten Aspekts, kann die Gehäusebefestigungsanformung zur gleichzeitigen Aufnahme des Befestigungsmittels und eines Kontakteinsatzbefestigungsmittels ausgebildet ist. Die Befestigungsanformung kann dabei eine Doppelfunktion aufweisen, nämlich die Aufnahme des Befestigungsmittels zur Befestigung des Anbaugehäuses an einer Gerätewand und die Aufnahme eines weiteren Befestigungsmittels, das zur Befestigung eines Kontaktträgers am Anbaugehäuse dient. Wird die Befestigungsanformung mit dieser Doppelfunktion ausgebildet, kann dies zu einer Materialeinsparung bei der Herstellung des Anbaugehäuses führen.

In einer weiteren Weiterbildung des ersten Aspekts, kann die rahmenförmige Grundform innenseitig mindestens eine Kontakteinsatzbefestigungsanformung mit einer zweiten Durchgangsöffnung aufweisen, wobei die Gehäusebefestigungsanformung und die zweite Befestigungsausformung derart angeordnet sein können, dass die Durchgangsöffnungen annähernd fluchten. Es sind zwei Anformungen vorgesehen, die unabhängig voneinander ausgebildet sein können. Beispielsweise kann die Durchgangsöffnung der Gehäusebefestigungsanformung einen anderen Durchmesser aufweisen als die Durchgangsöffnung der Kontakteinsatzbefestigungsanformung. Durch die Trennung der beiden Anformungen kann die Flexibilität der Anordnung und der zu verwendenden Befestigungsmittel erhöht werden. Durch die annähernd fluchtende Anordnung kann außerdem eine Durchgangsöffnung der einen Anformung durch die andere Durchgangsöffnung zugänglich sein. Dies kann das Einführen eines Werkzeugs ermöglichen oder zumindest erleichtern.

Ferner können die Gehäusebefestigungsanformung und die Kontakteinsatzbefestigungsanformung durch einen Spalt voneinander beabstandet sein. Dieser Spalt kann ein Volumen freigeben oder definieren, in das z. B. der Kopf des Befestigungsmittels eingebracht werden kann, der aufgrund der annähernd fluchtenden Anordnung der Durchgangsöffnungen durch eine der Durchgangsöffnungen mit dem Werkzeug zugänglich sein kann.

In einer weiteren Weiterbildung des ersten Aspekts, kann ein Durchmesser der ersten Durchgangsöffnung mindestens einem Durchmesser der zweiten Durchgangsöffnung entsprechen. Die Durchgangsöffnung kann dann in einem Arbeitsgang mit einem Werkzeug, z. B. einem Bohrer, zerspanend hergestellt werden.

In einer Weiterbildung des ersten Aspekts, kann der Durchmesser der zweiten Durchgangsöffnung mindestens einem Durchmesser einer Aufnahmestruktur des Kopfes zur Aufnahme des Werkzeugs entsprechen. Der Durchmesser ist vorzugsweise so zu wählen, dass das Werkzeug ausreichend Platz hat, um sich in der Durchgangsöffnung zu bewegen.

In einer bevorzugten Weiterbildung des ersten Aspekts, kann das Anbaugehäuse mit einer Mehrzahl von jeweils in einer Ecke der rahmenförmigen Grundform angeordneten Gehäusebefestigungsanformungen ausgebildet sein, die Gehäusebefestigungsanformungen mit jeweils einem in der ersten Durchgangsöffnung gelagerten Befestigungsmittel und mindestens zwei Kontakteinsatzbefestigungsanformungen, wobei zumindest eine Kontakteinsatzbefestigungsanformung derart angeordnet sein kann, dass ihre zweite Durchgangsöffnung mit einer ersten Durchgangsöffnung einer Gehäusebefestigungsanformung annähernd fluchtet.

Die Anordnung mehrerer Befestigungsmittel in mehreren Gehäusebefestigungsanformungen kann den Vorteil aufweisen, dass die Befestigungsmittel, wenn sie in mechanischem Eingriff mit der Gerätewand stehen, eine höhere Haltekraft auf das Anbaugehäuse ausüben können. Die Anordnung in den Ecken kann dagegen zu einer verbesserten Kraftverteilung und zu einer genaueren Einstellung des Anzugsmoments der Befestigungsmittel führen.

Die Weiterbildungen des ersten Aspekts können beliebig untereinander kombiniert werden, sofern dies sinnvoll und technisch möglich ist.

In einem zweiten Aspekt wird eine Baugruppe offenbart.

Die Baugruppe, umfassend eine Gerätewand mit einem Durchbruch, ein den Durchbruch umschließendes Anbaugehäuse nach dem ersten Aspekt (einschliesslich aller Weiterbildungen, sowie deren Kombination) sowie eine flexible Dichtung, wobei die flexible Dichtung zwischen der Gerätewand und dem Anbaugehäuse angeordnet ist und das Anbaugehäuse eine resultierende Kraft auf die flexible Dichtung ausübt, wenn sich die wendelförmige Struktur des zumindest einen Befestigungsmittels in mechanischem Eingriff mit der Gerätewand befindet.

Die resultierende Kraft kann die zuvor erwähnte Haltekraft sein, die bei einem bestimmten Anzugsmoment des Befestigungsmittels auf das Anbaugehäuse bzw. der wendelförmigen Struktur auf die Gerätewand ausgeübt wird. Die flexible Dichtung kann das Eindringen von Staub und/oder Wasser in das Anbaugehäuse verhindern und übt darüber hinaus eine Kraft auf die Gerätewand und das Anbaugehäuse aus, die der Haltekraft des Befestigungsmittels entgegenwirken kann. Die Baugruppe kann außerdem einen kompatiblen Steckverbinder umfassen, der in das Anbaugehäuse eingesteckt ist oder mit diesem in mechanischem Eingriff steht. Das Anbaugehäuse und der Steckverbinder bilden zusammen ein Steckverbindersystem "Stecker und Kupplung".

In einer Weiterbildung des zweiten Aspekts kann die durch das Anbaugehäuse auf die flexible Dichtung ausgeübte resultierende Kraft maximal sein, wenn sich das zumindest eine Befestigungsmittel in der Befestigungsstellung befindet. Wie bereits erwähnt, kann die Position der Befestigungsstellung von der Dicke und Beschaffenheit der Gerätewand abhängen.

### Ausführungsbeispiel

Ein Ausführungsbeispiel der Erfindung ist in den Zeichnungen dargestellt und wird im Folgenden näher erläutert. Es zeigen:
- Fig. 1: eine perspektivische Darstellung einer Baugruppe mit einer Gerätewand und einem Anbaugehäuse.
- Fig. 2: eine vergrößerte Ansicht des Befestigungsbereichs
- Fig. 3A-3C: eine Wendelendschraube aus verschiedenen Perspektiven
- Fig. 4: mehrere Wendelendschrauben im mechanischen Eingriff mit einer Gerätewand
- Fig. 5: eine Schnittdarstellung des Befestigungsbereichs mit einer Wendelendschrauben im mechanischen Eingriff mit einer Gerätewand

Die Figuren enthalten teilweise vereinfachte, schematische Darstellungen. Teilweise werden für gleiche, aber gegebenenfalls nicht identische Elemente identische Bezugszeichen verwendet. Verschiedene Ansichten gleicher Elemente könnten unterschiedlich skaliert sein. Richtungsangaben wie beispielsweise "links", "rechts", "oben" und "unten" sind mit Bezug auf die jeweilige Figur zu verstehen und können in den einzelnen Darstellungen gegenüber dem dargestellten Objekt variieren.

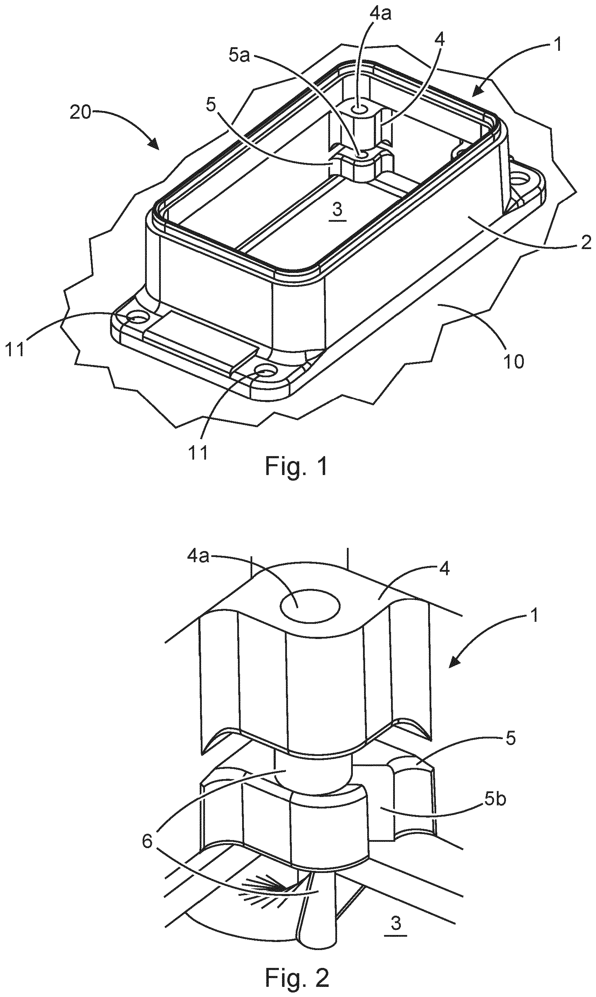

Figur 1 zeigt eine perspektivische Darstellung einer Baugruppe 20 mit einer Gerätewand 10 und einem Anbaugehäuse 1. In dem Ausführungsbeispiel ist das Anbaugehäuse 1 mangels einer Wendelendschraube nicht an der Gerätewand 10 befestigt. Das Anbaugehäuse 2 weist in einer Ecke eine Gehäusebefestigungsanformung 5 mit einer Durchgangsöffnung 5a auf, wobei der Schaft der Wendelendschraube in der Durchgangsöffnung 5a drehbar gelagert wäre. Oberhalb der Gehäusebefestigungsanformung 5 ist eine Kontakteinsatzbefestigungsanformung 4 mit einer Durchgangsöffnung 4a angeordnet. Diese Durchgangsöffnung weist ihrerseits ein Gewinde auf. Die Gehäusebefestigungsanformung 5 und die Kontakteinsatzbefestigungsanformung 4 sind voneinander beabstandet angeordnet, so dass zwischen ihnen ein Spalt gebildet ist, in dem der Schraubenkopf der Wendelendschraube gelagert wäre. In den Aufnahmebereich 3 kann ein Kontaktträger (nicht dargestellt) eingesetzt werden, der dann mit Schrauben befestigt wird, die in das Gewinde der Durchgangsöffnung 4a der Kontakteinsatzbefestigungsanformung 4 eingreifen. Die Rahmenstruktur des Anbaugehäuses 1 umschließt den Durchbruch der Gerätewand 10, wobei der Durchbruch im Aufnahmebereich 3 dargestellt ist und dann eine Durchgangsausnehmung in das Gerät darstellt.

An der rahmenförmigen Grundform 2 sind an ihrer Außenseite Befestigungsöffnungen 11 angebracht, über die das Anbaugehäuse 1 mit der Gerätewand 10 verschraubt werden kann. Diese Art der Befestigung ist alternativ zur Befestigung mittels Wendelendschrauben zu sehen, kann aber wahlweise auch kombiniert werden, um die Baugruppe 20 mechanisch noch formschlüssiger zu fixieren. Ein Steckverbindersystem würde gebildet, wenn auf das Anbaugehäuse 1 ein entsprechend ausgebildeter Steckverbinder, z. B. in Form eines Tüllengehäuses mit einem entsprechenden Kontakteinsatz, aufgesetzt wird.

Insgesamt weist das Anbaugehäuse 2 vier Gehäusebefestigungsanformungen 5 und vier Kontakteinsatzbefestigungsanformungen 4, die jeweils in den Ecken der rahmenförmigen Grundstrucktur 2 angeordnet sind. Diese sind in der Figur aufgrund der perspektivischen Ansicht nicht zu sehen.

Figur 2 zeigt eine vergrößerte Ansicht des Befestigungsbereichs des Anbaugehäuses 1 aus Figur 1, wobei zusätzlich die Kontakteinsatzbefestigungsanformung 4 und die Gehäusebefestigungsanformung 5 dargestellt sind. In der nicht dargestellten Durchgangsöffnung der Gehäusebefestigungsanformung 5 ist nun der Schaft einer Wendelendschraube 6 drehbar gelagert, deren Kopf sich in dem Spalt zwischen der Kontakteinsatzbefestigungsanformung 4 und der Gehäusebefestigungsanformung 5 befindet. Der Kopf ist durch die Durchgangsöffnung 4a der Kontakteinsatzbefestigungsanformung 4 zugänglich, so dass die Wendelendschraube 6 mit einem Werkzeug gedreht werden kann. Die Wendelendschraube 6 als solche wird durch die Ausnehmung 5b der Gehäusebefestigungsanformung 5 in die nicht dargestellte Durchgangsöffnung der Gehäusebefestigungsanformung 5 eingeführt. Alternativ kann auf die Ausnehmung 5b verzichtet werden und der Schaft der Wendelendschraube 6 mit einem Gewinde und der Kopf der Wendelendschraube 6 mit einem Gegengewinde ausgebildet sein, so dass die Wendelendschraube 6 nachträglich in die Gehäusebefestigungsanformung 5 eingeführt werden kann. Ferner könnte auch auf einen Kopf verzichtet werden, wenn die Ausnehmung 5b ein Innengewinde aufweisen würde und die Wendelendschraube 6 im oberen Bereich mit einem Außengewinde ausgebildet wäre.

Im unteren Teil der Figur ist die wendelförmige Struktur, kurz Wendel, der Wendelendschraube 6 im Aufnahmebereich 3 zu erkennen. Die Wendelendschraube 6 befindet sich in einer Befestigungsstellung, in der die wendelförmige Struktur in mechanischem Eingriff mit der Gerätewand steht und sodann das Anbaugehäuse 1 daran befestigt.

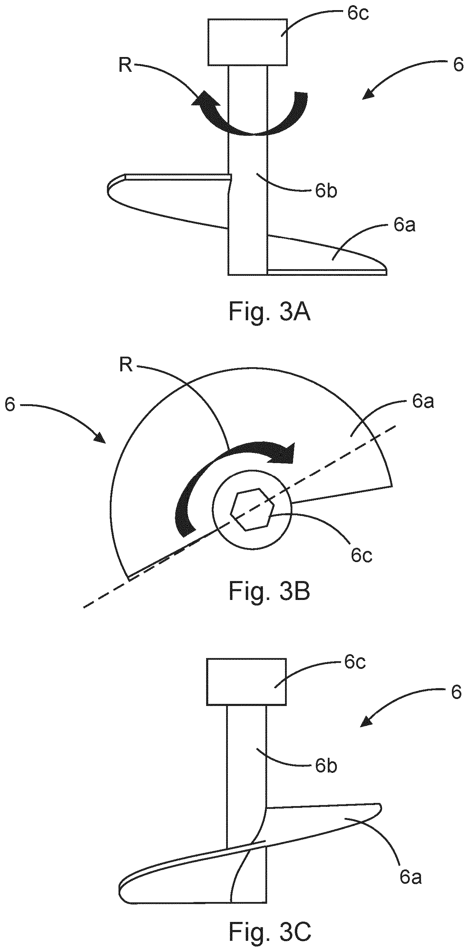

Die Figuren 3A bis 3C zeigen eine (die Gleiche) Wendelendschraube 6 aus verschiedenen Perspektiven. Die Wendelendschraube 6 in Figur 3A weist an einem Ende die wendelförmige Struktur 6a auf. In der gesamten Beschreibung kann "wendelförmig" als Synonym für schrauben-, spiral-, oder helixförmig verwendet werden. Die wendelförmige Struktur 6a windet sich entlang des Schafts 6b der Wendelendschraube 6. Die Wendelendschraube 6 weist außerdem einen Kopf oder Schraubenkopf 6c auf, der sich an einem anderen Ende der Wendelendschraube 6 befindet. Wie zu erkennen ist, ist die Wendelendschraube 6 in dem in den Figuren 1 und 2 dargestellten Anbaugehäuse drehbar gelagert, so dass sie um die dargestellte Rotationsachse R gedreht werden kann. Die Steigung der wendelförmigen Struktur 6a kann für den sicheren Halt des Anbaugehäuses von Bedeutung sein. Die Steigung der wendelförmigen Struktur 6a wird so gewählt, dass die Wendelendschraube 6 eine selbsthemmende Eigenschaft besitzt, wenn die wendelförmigen Struktur 6a mit der Gerätewand in mechanischen Eingriff steht. Das heißt, je geringer die Steigung der wendelförmigen Struktur 6a ist, desto selbsthemmender bzw. sicherer hält die Wendelendschraube 6 in der Befestigungsstellung. Ein größerer Bereich von Wandstärken des Gerätes kann abgedeckt werden, wenn die Steigung größer gewählt wird. Wie zu sehen ist, muss eine Balance zwischen Selbsthemmung bzw. Selbstsicherung und Flexibilität bei der Montage an Geräten mit unterschiedlichen Wanddicken gefunden werden. Die wendelförmigen Struktur 6a kann auch einen Bereich ohne Steigung aufweisen, d.h. rechtwinklig zur Drehachse. Dies kann nützlich sein, wenn das Anbaugehäuse an einer Gerätewand mit einer vorgegebenen Dicke befestigt werden soll. Sofern keine universelle Steigung der wendelförmigen Struktur 6a gefunden werden kann, kann der Kopf 6c eine raue Struktur aufweisen, die in Kombination mit Oberkante einer Gehäusebefestigungsanformung selbsthemmend wirkt. Die Verwendung einer Sperr-, Spann-, oder Federscheibe kann die Selbsthemmung bzw. Selbstsicherung zusätzlich verbessern. Die genannten Scheiben können zwischen dem Kopf 6c und der Oberkante einer Gehäusebefestigungsanformung angeordnet sein. Selbstverständlich kann die Oberfläche der wendelförmigen Struktur 6a auch so gestaltet werden, dass die Selbsthemmung bzw. Selbstsicherung erhöht wird. Dies kann durch eine Erhöhung der Oberflächenrauhigkeit oder durch eine entsprechende Haftbeschichtung erfolgen.

Figur 3B zeigt die Wendelendschraube 6 in einer Draufsicht. Wie zu sehen ist, weist der Kopf 6c eine Sechskantstruktur für den Eingriff eines Innensechskantschlüssels auf. Wie ebenfalls zu erkennen ist, vollführt die wendelförmige Struktur 6a etwas mehr als eine halbe Windung entlang der Rotationsachse R. Das bedeutet, je mehr sich die wendelförmige Struktur 6a einer vollständigen Windung nähert, desto größer ist der Bereich der Wanddicken der Gerätewand, der abgedeckt werden kann.

Figur 3C zeigt eine weitere Ansicht der Wendelendschraube 6, die der besseren Darstellung der wendelförmigen Struktur 6a dient. Es ist auch denkbar, den Kopf 6c in einer anderen Form, z. B. mit einem Sechskantkopf, auszuführen und diesen mit einem passenden Schraubenschlüssel, der dann in den Spalt greift, zu drehen.

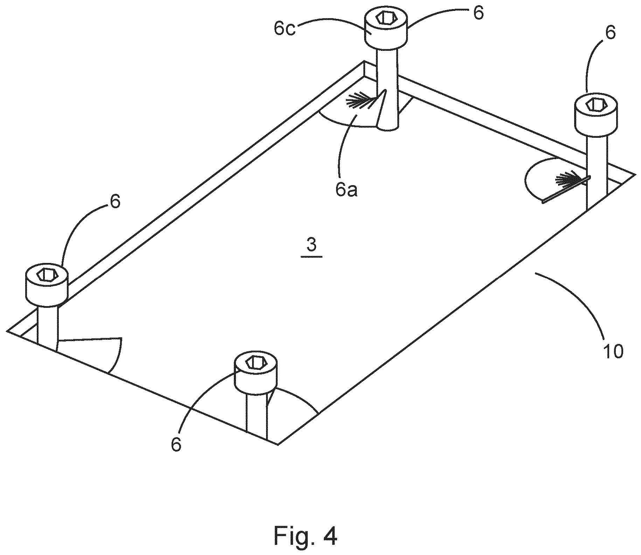

Figur 4 zeigt mehrere Wendelendschrauben 6 im mechanischen Eingriff mit einer Gerätewand 10. Die Wendelendschrauben 6 wurden aus dem Anbaugehäuse der Figur 1 herausgelöst, so dass ihr mechanischer Eingriff besser sichtbar ist. Wie zu erkennen ist, befinden sich die Wendelendschrauben 6 jeweils in einer Ecke. Ferner befinden sich die Wendelendschrauben 6 in der Befestigungsstellung, wodurch die wendelförmige Struktur 6a jeder Wendelendschraube 6 in mechanischem Eingriff mit der Gerätewand 10 steht, wodurch die wendelförmige Struktur 6a gegen die Unterseite (Gerätewandinnenseite) drückt und das nicht dargestellte Anbaugehäuse durch den Kopf der Wendelendschrauben 6 gegen die Oberseite (Gerätewandaußenseite) gedrückt wird. Die Drehung oder Rotation der Wendelendschrauben 6 in die Befestigungsstellung beträgt in diesem Ausführungsbeispiel etwa 120 Grad, also ungefähr einem Drittel einer Windung.

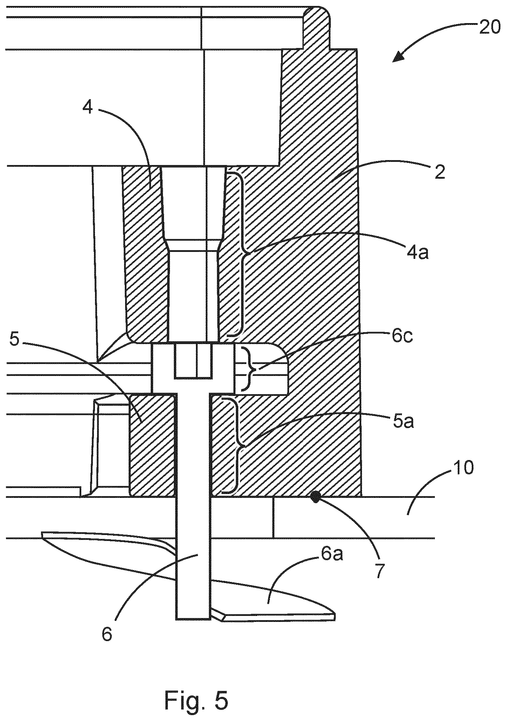

Figur 5 zeigt eine Schnittdarstellung des Befestigungsbereichs mit einer Wendelendschraube 6 im mechanischen Eingriff mit einer Gerätewand 10. Wie zu erkennen ist, befindet sich der Kopf 6c im Spalt zwischen der Kontakteinsatzbefestigungsanformung 4 und der Gehäusebefestigungsanformung 5, wobei der Kopf 6c durch die Durchgangsöffnung 4a der Kontakteinsatzbefestigungsanformung 4 zugänglich ist. Die Wendelendschrauben 6 befinden sich ebenfalls in Befestigungsstellung, wodurch der Kopf 6c gegen die Gehäusebefestigungsanformung 5 drückt und das Anbaugehäuse 1 dabei in Richtung der Gerätewand 10 gedrückt wird. Die wendelförmige Struktur 6a drückt dabei gegen die Unterseite der Gerätewand 10. Die flexible Dichtung 7 umschließt den Wanddurchbruch und wirkt der durch den Kopf 6c auf das Anbaugehäuse 1 ausgeübten Anpresskraft entgegen. Die flexible Dichtung dichtet daraufhin die Baugruppe 20 ab.

Auch wenn in den Figuren verschiedene Aspekte oder Merkmale der Erfindung jeweils in Kombination gezeigt sind, ist für den Fachmann - soweit nicht anders angegeben - ersichtlich, dass die dargestellten und diskutierten Kombinationen nicht die einzig möglichen sind. Insbesondere können einander entsprechende Einheiten oder Merkmalskomplexe aus unterschiedlichen Ausführungsbeispielen miteinander ausgetauscht werden.

### Bezugszeichenliste

- 1: Anbaugehäuse
- 2: Grundform, rahmenförmig
- 3: Aufnahmebereich
- 4: Kontakteinsatzbefestigungsanformung
- 4a: Durchgangsöffnung von Kontakteinsatzbefestigungsanformung
- 5: Gehäusebefestigungsanformung
- 5a: Durchgangsöffnung von Gehäusebefestigungsanformung
- 5b: Ausnehmung von Gehäusebefestigungsanformung
- 6: Befestigungsmittel, Wendelendschraube
- 6a: Wendelförmige Struktur, Wendel
- 6b: Schaft
- 6c: Wendelendschraubenkopf
- 7: Dichtung
- 10: Gerätewand
- 11: Schrauböffnungen an Schmalseiten
- 20: Baugruppe
- R: Rotationsachse, Drehbewegung

## Patentansprüche

1. Anbaugehäuse (1) mit einer rahmenförmigen Grundform (2), welche einen Aufnahmebereich (3) zur Aufnahme eines Kontakteinsatzes umschließt, wobei die rahmenförmige Grundform (2) innenseitig mindestens eine Gehäusebefestigungsanformung (5) mit einer ersten Durchgangsöffnung (5a) zur Aufnahme eines Befestigungsmittels (6) aufweist, das Anbaugehäuse (1) ferner umfassend ein Befestigungsmittel (6), das zumindest teilweise in der ersten Durchgangsöffnung (5a) der Gehäusebefestigungsanformung (5) drehbar gelagert angeordnet ist, **dadurch gekennzeichnet, dass** das Befestigungsmittel (6) an einem Ende eine wendelförmige Struktur (6a) aufweist, wobei die wendelförmige Struktur (6a) zumindest teilweise aus der rahmenförmigen Grundform (2) herausragt.

2. Anbaugehäuse (1) nach Anspruch 1, wobei das Befestigungsmittel (6) zwischen zwei Endstellungen drehbar ist, die einer Montagestellung und einer Befestigungsstellung entsprechen, wobei die wendelförmige Struktur (6a) in der Befestigungsstellung zumindest teilweise aus der rahmenförmigen Grundform (2) herausragt.

3. Anbaugehäuse (1) nach Anspruch 1 oder 2, wobei die wendelförmige Struktur (6a) als Wendel mit mindestens einer zwölftel Windung und höchstens einer ganzen Windung ausgebildet ist.

4. Anbaugehäuse (1) nach einem der Ansprüche 1 bis 3, wobei die wendelförmige Struktur (6a) bezüglich einer Rotationsachse (R) rotationsasymmetrisch, ausgebildet ist.

5. Anbaugehäuse (1) nach einem der Ansprüche 1 bis 4, wobei das Befestigungsmittel (6) einen zur Aufnahme eines Werkzeugs ausgebildeten Kopf (6c) aufweist, der an einem der wendelförmigen Struktur (6a) abgewandten Ende angeordnet ist.

6. Anbaugehäuse (1) nach einem der Ansprüche 1 bis 5, wobei die Gehäusebefestigungsanformung (5) zur gleichzeitigen Aufnahme des Befestigungsmittels (6) und eines Kontakteinsatzbefestigungsmittels ausgebildet ist.

7. Anbaugehäuse (1) nach einem der Ansprüche 1 bis 5, wobei die rahmenförmige Grundform (2) innenseitig mindestens eine Kontakteinsatzbefestigungsanformung (4) mit einer zweiten Durchgangsöffnung (4a) aufweist, wobei die Gehäusebefestigungsanformung (5) und die zweite Befestigungsausformung (4, 5) derart angeordnet sind, dass die Durchgangsöffnungen (4a, 5a) annähernd fluchten.

8. Anbaugehäuse (1) nach Anspruch 7, wobei die Gehäusebefestigungsanformung (5) und die Kontakteinsatzbefestigungsanformung (4) durch einen Spalt voneinander beabstandet sind.

9. Anbaugehäuse (1) nach den Ansprüchen 6 und 8, wobei der Kopf (6c) des Befestigungsmittels (6) im Spalt angeordnet ist.

10. Anbaugehäuse (1) nach einem der Ansprüche 7 bis 9, wobei ein Durchmesser der ersten Durchgangsöffnung (5a) mindestens einem Durchmesser der zweiten Durchgangsöffnung (4a) entspricht.

11. Anbaugehäuse (1) nach Anspruch 10, wobei der Durchmesser der zweiten Durchgangsöffnung (4a) mindestens einem Durchmesser einer Aufnahmestruktur des Kopfes (6c) zur Aufnahme des Werkzeugs entspricht.

12. Anbaugehäuse (1) nach einem der Ansprüche 7 bis 11, mit einer Mehrzahl von jeweils in einer Ecke der rahmenförmigen Grundform (2) angeordneten Gehäusebefestigungsanformungen (5) mit jeweils einem in der ersten Durchgangsöffnung gelagerten Befestigungsmittel (6) und vorzugsweise mit mindestens zwei Kontakteinsatzbefestigungsanformungen, wobei zumindest eine Kontakteinsatzbefestigungsanformung (4) derart angeordnet ist, dass ihre zweite Durchgangsöffnung (4a) mit einer ersten Durchgangsöffnung (5a) einer Gehäusebefestigungsanformung (5) annähernd fluchtet.

13. Baugruppe (20), umfassend eine Gerätewand (10) mit einem Durchbruch, ein den Durchbruch umschließendes Anbaugehäuse (1) nach einem der Ansprüche 1 bis 12 sowie eine flexible Dichtung, wobei die flexible Dichtung zwischen der Gerätewand (10) und dem Anbaugehäuse (1) angeordnet ist und das Anbaugehäuse (1) eine resultierende Kraft auf die flexible Dichtung ausübt, wenn sich die wendelförmige Struktur (6a) des zumindest einen Befestigungsmittels (6) in mechanischem Eingriff mit der Gerätewand (10) befindet.

14. Baugruppe (20) nach Anspruch 13, wobei die durch das Anbaugehäuse (1) auf die flexible Dichtung ausgeübte resultierende Kraft maximal ist, wenn sich das zumindest eine Befestigungsmittel (6) in der Befestigungsstellung befindet.
